# EUROPEAN PATENT SPECIFICATION

(11) **EP 2 562 932 B1**
(45) Date of publication and mention of the grant of the patent: **19.11.2014**
(21) Application number: 11178768.5
(22) Date of filing: 25.08.2011
(51) Int. Cl.: H03F 3/217, G01R 31/27, G01R 31/28, G01R 31/30

(54) **Integrated circuit**
Integrierte Schaltung
Circuit intégré

(43) Date of publication of application: 27.02.2013
(73) Proprietor: NXP B.V., 5656 AG Eindhoven (NL)
(72) Inventor: Berkhout, Marco, Redhill, Surrey RH1 1DL (GB)
(74) Representative: Crawford, Andrew

(56) References cited:
- US-A1- 2005 110 521
- US-A1- 2009 322 426
- US-A1- 2011 050 272
- US-B1- 6 313 657
- US-B1- 6 337 819

## Description

The invention relates to an integrated circuit comprising a first pair of switching devices arranged in series between positive and negative supply terminals and to a method of testing such an integrated circuit.

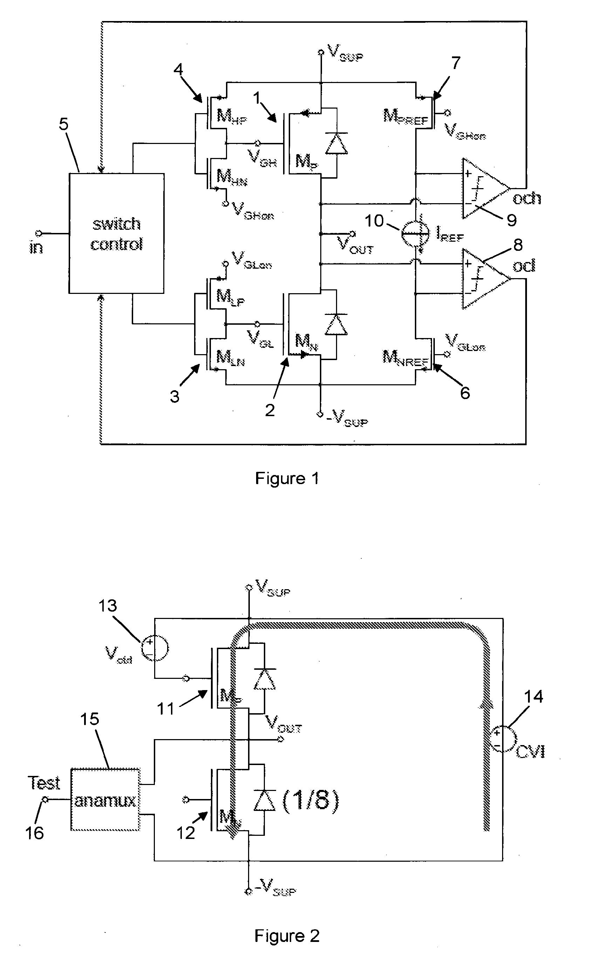

Class-D amplifiers are commonly used as speaker drivers in consumer, automotive and mobile applications. An essential part of a class-D amplifier is the output stage, a typical example of which is shown in Figure 1. It consists of two very large power transistors 1 and 2 that alternately connect the output node ***V_{OUT}*** to the negative (-V_{SUP}) or positive (V_{SUP})supply rail.

The gate of the low-side power transistor 2 is controlled by a gate driver 3 that charges the gate to a maximum voltage V_{GLon} to switch it on or shorts the gate to the source to switch it off. The gate driver 4 of the high-side power transistor 1 is complementary. The gate drivers are controlled by a switch control logic circuit 5.

Also shown in Figure 1 are the over-current detection circuits formed by reference transistors 6, 7 and comparators 8, 9. Over-current detection is generally used in power amplifiers to protect them from overloading and make them robust against short circuits. The over-current detection is done by comparing the drain-source voltage of the power transistors 1 and 2 to that of the much smaller reference transistors 6 and 7 that are biased with a constant reference current ***I_{REF}*** generated by reference current source 10. The outputs of comparators 8, 9 are only valid if the corresponding power transistors 1, 2 are on. In this case the reference 6, 7 and power transistors 1, 2 have equal gate and source voltages. If the width to length aspect ratio of the power transistors is ***N*** times larger than that of the reference transistors then the over-current threshold for the power transistors equals ***N*I_{REF}***.

Similar circuits to this output stage are also used in switch mode power supply controller devices.

Integrated circuits comprising this kind of output stage are produced in high volumes and in order to guarantee the quality of each product they are industrially tested on wafer, i.e. before sawing and packaging. Industrial testing is done with dedicated test equipment, known as a tester, that includes programmable signal and supply generators, voltage and current meters and digital interfaces. The individual integrated circuits are contacted with needle probes that are precisely arranged on a so-called probe card to exactly match the positions of the bonding pads of the integrated circuits under test.

The power transistors in a class-D output stage cover a substantial chip area and are tested thoroughly for gate-leakage and on-resistance. For the on-resistance test the power transistor to be tested is switched on and the drain-source voltage is measured while a large current is applied. Preferably, the current is equal or close to the over-current threshold. This makes the measurement representative of a realistic application and allows for testing of the over-current detection circuitry. However, the maximum current that can be handled by the needle probes is usually less than the over-current threshold of the power transistors. This problem is solved by splitting the power transistor into *M* smaller sections that can be tested sequentially at *M* times a smaller current. The measurement current is controlled by using an array of external resistors that can be switched using relays.

In a typical case, the power transistor has 8 sections that are switched on one at a time. The current is increased stepwise by closing relays until the over-current detection is triggered. The external current is supplied and measured by an instrument known as a controlled voltage-current source-meter (CVI). The drain-source voltage is measured by means of an analogue multiplexer that connects the drain and source of the power transistor to a test pin or pad. The resistors and relays are assembled on a circuit board called a handler that also contains the probe card and serves as an interface between the device under test (DUT) and the tester.

The cost of the industrial test is a significant part of the total product price and is proportional to the total time of the test. In order to speed up test time it is advantageous to test DUTs in parallel. Preferably, multiple DUTs are contacted with one single probe card to enable parallel testing of devices. However, the amount of space on the handler is limited. In some cases this means that the external hardware required to do the on-resistance measurements is actually the limiting factor in the number of devices that can be tested in parallel.

Another problem relates to the speed and accuracy of measurement. The procedure of decreasing the external resistance by subsequently closing relays is relatively slow and has limited resolution.

Prior art IC's with built-in test features are taught in US2005/0110521, US2011/0050272, US2009/0322426, and US6337819.

According to a first aspect of the invention, there is provided an integrated circuit comprising a first pair of switching devices arranged in series between positive and negative supply terminals, wherein the integrated circuit is switchable between an operational mode, in which the first pair of switching devices are driven to couple either the positive or negative supply terminal to an output terminal, and a test mode, in which a current source on the integrated circuit is driven to cause a desired current to flow in a first one of the first pair of switching devices.

By making use of an integrated current source instead of using external switchable resistors, the invention overcomes the problems set out above as all external components on the handler can be eliminated. Furthermore, the use of relays is avoided, thereby speeding up the testing procedure.

Typically, the current source is the second one of the first pair of switching devices. Thus, the complementary power transistor may be used as the current source to cause the desired current to flow in the first one of the first pair of switching devices.

Alternatively, the current source is one of a second pair of switching devices on the integrated circuit. In this case, an external connection will be provided that connects the output terminals of the first and second pairs of switching devices so that a current path exists between the two. This has the advantage that the connection to the output terminals is also stressed and tested.

In another embodiment, the current source is a plurality of switching devices, each forming one of a plurality of pairs of switching devices on the integrated circuit. This has the advantage that the power dissipation in the current source during the test is distributed over a larger area, which reduces the temperature increase.

Typically, the first pair of switching devices is a pair of complementary MOSFET transistors.

The integrated circuit may further comprise an over-current detection circuit adapted to detect an excessive current flowing in the first one of the first pair of switching devices when in the operational mode and to drive the current source to cause the desired current to flow when in the test mode. By "excessive current", we mean a current in excess of an over-current limit or threshold. The current can be regulated to the desired current by using the over-current detection circuit as error amplifier in a feedback loop. By regulating the desired current to a level just below and subsequently just above the over-current threshold the functionality of the over-current detection is tested without the need for a sequence in the test program to determine this level by switching a resistor bank.

The over-current detection circuit preferably comprises a transconductance amplifier configured, when in the test mode, to drive the current source with a signal representing the difference between the voltage at the output terminal and a reference voltage, and a voltage offset circuit controllable to add or subtract an offset voltage from the difference.

The transconductance amplifier and voltage offset circuit are typically configured to enter a high impedance state when in the operational mode.

The integrated circuit normally further comprises a driver circuit for driving the second one of the first pair of switching devices when in the operational mode, wherein the driver circuit is configured to enter a high impedance state when in the test mode.

The integrated circuit may further comprise an analogue multiplexer for measuring the voltage across the first one and/or the second one of the first pair of switching devices. The on-resistance can be calculated as the ratio of the measured voltage (e.g. the drain-source voltage when the switching devices are MOSFETs) and the supply current.

The first pair of switching devices typically forms part of a class-D audio amplifier or of a switch mode power supply controller.

In accordance with a second aspect of the invention, there is provided a method of testing an integrated circuit according to the first aspect of the invention, the method comprising switching the integrated circuit into the test mode, driving the current source on the integrated circuit to cause the desired current to flow in the first one of the first pair of switching devices, and analysing an output signal in accordance with a predetermined test protocol.

In one embodiment, the desired current is in excess of an over-current limit and the output signal is an over-current detection signal indicating that an excessive current is flowing in the first one of the first pair of switching devices.

In another embodiment, the output signal is the voltage across the first one of the first pair of switching devices. This enables the on-resistance to be calculated from the output signal representing the voltage across the first one of the first pair of switching devices and the current supplied to the first one of the first pair of switching devices.

Examples of the invention will now be described in detail with reference to the accompanying drawings, in which:
Figure 1 shows a prior art class-D output stage;
Figure 2 shows an embodiment of the invention;
Figure 3 shows an enhancement of the embodiment of Figure 2; and
Figure 4 shows an operational transconductance amplifier with a controllable offset.

In Figure 2, a PMOS power transistor 11 is coupled in series with an NMOS power transistor 12 between positive (***V_{SUP}***) and negative (-***V_{SUP}***) supply rails. The PMOS and NMOS power transistors 11, 12 form part of the output stage of a Class-D amplifier and are on an integrated circuit. The integrated circuit is switchable between operational and test modes. In the operational mode, the PMOS and NMOS power transistors 11, 12 are driven by a driver circuit (not shown) to produce an output signal that is an amplified version of an input signal.

In the test mode, the PMOS power transistor 11 is biased by a voltage source 13, also on the integrated circuit, to act as a current source for use in on-resistance measurement of the NMOS power transistor 12. The path of the current is shown in Figure 2 by the arrow, and it flows from the CVI 14 to the source of PMOS power transistor 11, through the PMOS power transistor 11 and into NMOS power transistor 12. The current is measured by the CVI and the drain-source voltage of NMOS power transistor 12 is measured using an analogue multiplexer 15, which produces an output signal at test pin 16. The on-resistance of NMOS power transistor 12 can thus be determined by dividing the measured voltage by the measured current.

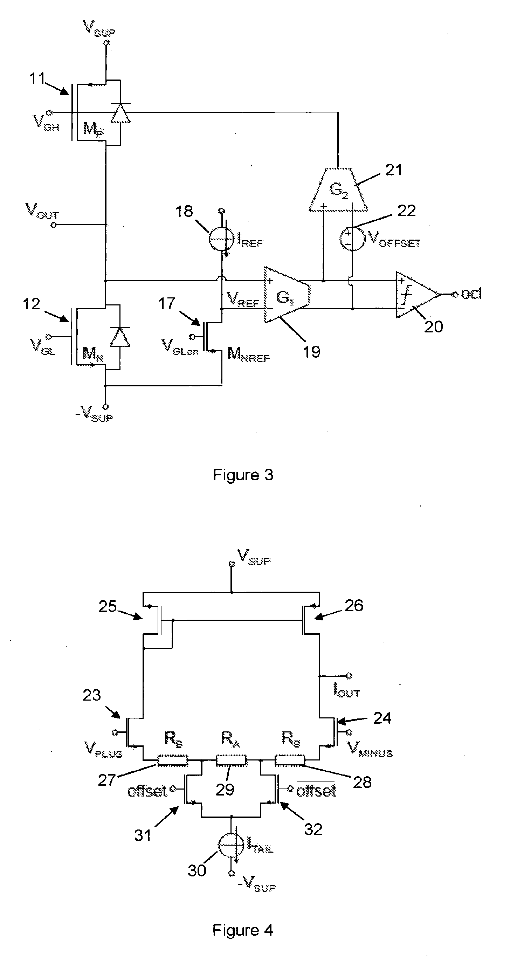

There are various ways in which the appropriate control voltage ***V_{ctrl}*** can be generated to drive the gate of the PMOS power transistor 11. A particularly advantageous way is to use an over-current detection circuit integrated with the NMOS power transistor 12 as shown in Figure 3.

The over-current detection circuit comprises an NMOS reference transistor 17 that has a width to length aspect ratio ***N*** times smaller than that of NMOS power transistor 12 and a reference current source 18 in series with the reference transistor 17. The reference current, ***I_{REF},*** is selected to be ***N*** times smaller than the over-current limit or threshold of NMOS power transistor 12 such that the drain-source voltage of both the NMOS power transistor 12 and the NMOS reference transistor 17 will be the same when the current flowing through the NMOS power transistor 12 reaches the over-current limit. A linear amplifier 19 amplifies the voltage difference between ***V_{OUT}*** (the drain voltage of the NMOS power transistor 12) and ***V_{REF}*** (the drain voltage of the NMOS reference transistor 17). The output from the linear amplifier 19 is coupled to a comparator 20 that is triggered when ***V_{OUT}*** exceeds ***V_{REF}*** and causes the driver circuit to shut down to prevent NMOS power transistor 12 from being damaged.

The amplified voltage difference at the output of linear amplifier 19 is also used to drive an operational transconductance amplifier (OTA) 21 that controls the gate voltage of the PMOS power transistor 11. An offset circuit 22 applies a small offset voltage ***V_{OFFSET}*** to the input of OTA 21. The polarity of ***V_{OFFSET}*** can be switched. Thus, the current through PMOS power transistor 11 is, depending on the sign of ***V_{OFFSET},*** set to just below or just above the over-current threshold ***N*I_{REF}***. In this way, the functionality of the over-current detection circuit can be tested.

The stability of the feedback loop formed by the addition of OTA 21 and offset circuit 22 to the over-current detection circuit is guaranteed by a dominant pole formed by OTA 21 and the very large input capacitance of PMOS power transistor 11.

Clearly, a complementary loop can be used to measure the on-resistance and over-current threshold level of the PMOS power transistor 11. In this case the NMOS power transistor 12 is used as the current source.

When in the test mode as shown in Figure 3, the gate-driver circuit of PMOS power transistor 11 is put into a high-impedance mode. On the other hand, during operational mode, the OTA 21 is put into a high-impedance mode.

A very simple circuit for an OTA that has a controllable offset voltage is shown in Figure 4; this therefore combines the functions of OTA 21 and offset circuit 22 shown in Figure 3. In this circuit a long-tailed pair is formed from transistors 23, 24, which have a current mirror formed of transistors 25, 26 as their load. A set of three resistors 27, 28, 29 is provided between the sources of transistors 23, 24. The resistor 29 is shared between the two source circuits of transistors 23, 24. The current in the long-tailed pair is provided by a tail current source 30 coupled to either side of the resistor 29 by respective transistors 31, 32. The transistors 31, 32 are supplied with an input signal ***offset*** and its inverse. Thus, when transistor 31 is on, transistor 32 is off and vice-versa. This ensures that the source voltages of transistors 23, 24 will always be slightly offset from each other. Thus, depending on the value of the digital input signal ***offset*** the input referred offset voltage is plus or minus ***I_{TAIL}*×*R_{A}.*** This circuit is the only additional hardware required for the measurement loop shown in Figure 3. All other elements are already available in the circuit of Figure 1. The OTA 21 is caused to enter the high-impedance mode by reducing the tail current ***I_{TAIL}*** to zero. For the complementary control loop the same circuit can be used in a complementary arrangement. In testing, we have found that toggling the input signal offset causes a small variation in current supplied to NMOS power transistor 12, which is sufficient to trigger the ***ocl*** signal at the output of comparator 20.

As an alternative to the configuration shown in Figure 3, the PMOS power transistor used to supply current to NMOS power transistor 12 does not necessarily have to be in the same branch. If more than one class-D half-bridges (i.e. pairs of NMOS and PMOS power transistors) are on the same chip, the PMOS power transistor of one of the other half-bridges can be used as the current source. In this case an external connection has to be provided that connects the outputs of the two half-bridges so that a current path between the two is possible. This has the advantage that the connections to the outputs are stressed and tested.

Another alternative is to use the PMOS power transistors of all available class-D output stages together as a single current source. This has the advantage that the dissipation in the PMOS power transistors during the test is distributed over a larger area, which reduces the temperature increase.

This type of half-bridge is found in class-D audio amplifiers and DC-DC converters, and the invention can be applied in both types of circuit.

Other variations to the disclosed embodiments can be understood and effected by those skilled in the art in practising the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. An integrated circuit comprising a first pair (11, 12) of switching devices arranged in series between positive and negative supply terminals, wherein the integrated circuit is switchable between an operational mode, in which the first pair (11, 12) of switching devices are driven to couple either the positive or negative supply terminal to an output terminal, and a test mode, in which a current source on the integrated circuit is driven to cause a desired current to flow in a first one (12) of the first pair (11, 12) of switching devices.

2. An integrated circuit according to claim 1, wherein the current source is the second one (11) of the first pair of switching devices.

3. An integrated circuit according to claim 1, wherein the current source is one of a second pair of switching devices on the integrated circuit.

4. An integrated circuit according to claim 1, wherein the current source is a plurality of switching devices, each forming one of a plurality of pairs of switching devices on the integrated circuit.

5. An integrated circuit according to any of the preceding claims, wherein the first pair (11, 12) of switching devices is a pair of complementary MOSFET transistors.

6. An integrated circuit according to any of the preceding claims, further comprising an over-current detection circuit adapted to detect an excessive current flowing in the first one of the first pair of switching devices when in the operational mode and to drive the current source to cause the desired current to flow when in the test mode.

7. An integrated circuit according to claim 6, wherein the over-current detection circuit comprises a transconductance amplifier (21) configured, when in the test mode, to drive the current source with a signal representing the difference between the voltage at the output terminal and a reference voltage, and a voltage offset circuit (22) controllable to add or subtract an offset voltage from the difference.

8. An integrated circuit according to claim 7, wherein the transconductance amplifier (21) and voltage offset circuit (22) are configured to enter a high impedance state when in the operational mode.

9. An integrated circuit according to any of the preceding claims, further comprising a driver circuit for driving the second one (11) of the first pair of switching devices when in the operational mode, wherein the driver circuit is configured to enter a high impedance state when in the test mode.

10. An integrated circuit according to any of the preceding claims, further comprising an analogue multiplexer (15) for measuring the voltage across the first one and/or the second one of the first pair of switching devices.

11. An integrated circuit according to any of the preceding claims, wherein the first pair (11, 12) of switching devices forms part of a class-D audio amplifier or of a switch mode power supply controller.

12. A method of testing an integrated circuit according to any of the preceding claims, the method comprising switching the integrated circuit into the test mode, driving the current source on the integrated circuit to cause the desired current to flow in the first one (12) of the first pair of switching devices, and analysing an output signal in accordance with a predetermined test protocol.

13. A method according to claim 12, wherein the desired current is in excess of an over-current limit and the output signal is an over-current detection signal indicating that an excessive current is flowing in the first one (12) of the first pair of switching devices.

14. A method according to claim 12, wherein the output signal is the voltage across the first one (12) of the first pair of switching devices.

## Patentansprüche

1. Ein integrierter Schaltkreis aufweisend
ein erstes Paar (11, 12) von Schaltvorrichtungen, welche in Serie angeordnet sind zwischen einem positiven und einem negativen Versorgungsanschluss, wobei der integrierte Schaltkreis schaltbar ist zwischen einem Betriebsmodus, in welchem das erste Paar (11, 12) von Schaltvorrichtungen angetrieben wird, entweder den positiven oder den negativen Versorgungsanschluss mit einem Ausgangsanschluss zu koppeln, und einem Prüfmodus, in welchem eine Stromquelle auf dem integrierten Schaltkreis angetrieben wird, um einen gewünschten Strom zu veranlassen, in einer ersten (12) des ersten Paars (11, 12) von Schaltvorrichtungen zu fließen.

2. Ein integrierter Schaltkreis gemäß Anspruch 1, wobei die Stromquelle die zweite (11) des ersten Paars von Schaltvorrichtungen ist.

3. Ein integrierter Schaltkreis gemäß Anspruch 1, wobei die Stromquelle eine von einem zweiten Paar von Schaltvorrichtungen auf dem integrierten Schaltkreis ist.

4. Ein integrierte Schaltkreis gemäß Anspruch 1, wobei die Stromquelle eine Mehrzahl von Schaltvorrichtungen ist, wobei jede eines von einer Mehrzahl von Paaren von Schaltvorrichtungen auf dem integrierten Schaltkreis bildet.

5. Ein integrierte Schaltkreis gemäß irgendeinem der vorangehenden Ansprüche, wobei das erste Paar (11, 12) von Schaltvorrichtungen ein Paar von komplementären MOSFET Transistoren ist.

6. Ein integrierte Schaltkreis gemäß irgendeinem der vorangehenden Ansprüche, ferner aufweisend einen Überstrom Detektionsschaltkreis, welcher eingerichtet ist, um einen überhöhten Strom zu detektieren, welcher in der ersten des ersten Paars von Schaltvorrichtungen fließt, wenn der Betriebsmodus vorliegt, und um die Stromquelle anzutreiben, um den gewünschten Strom zu veranlassen zu fließen, wenn der Prüfmodus vorliegt.

7. Ein integrierte Schaltkreis gemäß Anspruch 6, wobei der Überstrom Detektionsschaltkreis aufweist
einen Transkonduktanz Verstärker (21), welcher konfiguriert ist, die Stromquelle mit einem Signal anzutreiben, welches die Differenz darstellt zwischen der Spannung an dem Ausgangsanschluss und einer Referenz Spannung, wenn der Prüfmodus vorliegt, und
einen Spannungsoffset Schaltkreis (22), welcher steuerbar ist, um eine Offset Spannung zu der Differenz zu addieren oder zu subtrahieren.

8. Ein integrierte Schaltkreis gemäß Anspruch 7, wobei der Transkonduktanz Verstärker (21) und der Spannungsoffset Schaltkreis (22) konfiguriert sind, in einen hochohmigen Zustand einzutreten, wenn der Betriebsmodus vorliegt.

9. Ein integrierte Schaltkreis gemäß irgendeinem der vorangehenden Ansprüche, ferner aufweisend
einen Antriebsschaltkreis zum Antreiben der zweiten (11) des ersten Paares von Schaltvorrichtungen, wenn der Betriebsmodus vorliegt, wobei der Antriebsschaltkreis konfiguriert ist, in einen hochohmigen Zustand einzutreten, wenn der Prüfmodus vorliegt.

10. Ein integrierte Schaltkreis gemäß irgendeinem der vorangehenden Ansprüche, ferner aufweisend
einen analogen Multiplexer (15) zum Messen der Spannung über der ersten und/oder der zweiten des ersten Paares von Schaltvorrichtungen.

11. Ein integrierte Schaltkreis gemäß irgendeinem der vorangehenden Ansprüche, wobei das erste Paar (11, 12) von Schaltvorrichtungen einen Teil eines Klasse-D Audio Verstärkers oder einer Schaltungsmodus Energieversorgungssteuerung bildet.

12. Ein Verfahren zum Prüfen eines integrierten Schaltkreises gemäß einem der vorangehenden Ansprüche, wobei das Verfahren aufweist
Schalten des integrierten Schaltkreises in den Prüfmodus,
Antreiben der Stromquelle auf dem integrierten Schaltkreis, um den gewünschten Strom zu veranlassen, in die erste (12) des ersten Paars von Schaltvorrichtungen zu fließen, und
Analysieren eines Ausgangssignals gemäß einem vorbestimmten Prüfprotokoll.

13. Ein Verfahren gemäß Anspruch 12, wobei der gewünschte Strom über einer Überstromgrenze liegt und das Ausgangssignal ein Überstrom Detektionssignal ist, welches anzeigt, dass ein Überstrom in der ersten (12) des ersten Paars von Schaltvorrichtungen fließt.

14. Ein Verfahren gemäß Anspruch 12, wobei das Ausgangssignal die Spannung über der ersten (12) des ersten Paars von Schaltvorrichtungen ist.

## Revendications

1. Circuit intégré, comprenant une première paire (11, 12) de dispositifs de commutation montés en série entre des bornes d'alimentation positive et négative, lequel circuit intégré est commutable entre un mode opérationnel dans lequel la première paire (11, 12) de dispositifs de commutation est commandée pour coupler soit la borne d'alimentation positive, soit la borne d'alimentation négative à une borne de sortie, et un mode de test dans lequel une source de courant sur le circuit intégré est commandée pour faire circuler un courant désiré dans un premier (12) de la première paire (11, 12) de dispositifs de commutation.

2. Circuit intégré selon la revendication 1, dans lequel la source de courant est le deuxième (11) de la première paire de dispositifs de commutation.

3. Circuit intégré selon la revendication 1, dans lequel la source de courant est l'un d'une deuxième paire de dispositifs de commutation sur le circuit intégré.

4. Circuit intégré selon la revendication 1, dans lequel la source de courant est une pluralité de dispositifs de commutation, formant chacun l'une d'une pluralité de paires de dispositifs de commutation sur le circuit intégré.

5. Circuit intégré selon l'une quelconque des revendications précédentes, dans lequel la première paire (11, 12) de dispositifs de commutation est une paire de transistors MOSFET complémentaires.

6. Circuit intégré selon l'une quelconque des revendications précédentes, comprenant en outre un circuit de détection de surintensité adapté à détecter la circulation d'un courant excessif dans le premier de la première paire de dispositifs de commutation lorsque le circuit intégré est en mode opérationnel, et à commander la source de courant pour faire circuler le courant désiré lorsque le circuit intégré est en mode de test.

7. Circuit intégré selon la revendication 6, dans lequel le circuit de détection de surintensité comprend un amplificateur à transconductance (21) configuré, lorsque le circuit intégré est en mode de test, pour commander la source de courant au moyen d'un signal représentant la différence entre la tension à la borne de sortie et une tension de référence, et un circuit de décalage en tension (22) pilotable pour ajouter une tension de décalage à la différence ou soustraire une tension de décalage de la différence.

8. Circuit intégré selon la revendication 7, dans lequel l'amplificateur à transconductance (21) et le circuit de décalage en tension (22) sont configurés pour adopter un état de haute impédance lorsque le circuit intégré est en mode opérationnel.

9. Circuit intégré selon l'une quelconque des revendications précédentes, comprenant en outre un circuit de commande servant à commander le deuxième (11) de la première paire de dispositifs de commutation lorsque le circuit intégré est en mode opérationnel, lequel circuit de commande est configuré pour adopter un état de haute impédance lorsque le circuit intégré est en mode de test.

10. Circuit intégré selon l'une quelconque des revendications précédentes, comprenant en outre un multiplexeur analogique (15) servant à mesurer la tension aux bornes du premier et/ou du deuxième de la première paire de dispositifs de commutation.

11. Circuit intégré selon l'une quelconque des revendications précédentes, dans lequel la première paire (11, 12) de dispositifs de commutation fait partie d'un amplificateur audio classe D ou d'un contrôleur d'alimentation à découpage.

12. Procédé permettant de tester un circuit intégré selon l'une quelconque des revendications précédentes, le procédé consistant à commuter le circuit intégré sur le mode de test, commander la source de courant sur le circuit intégré pour faire circuler le courant désiré dans le premier (12) de la première paire de dispositifs de commutation, et analyser un signal de sortie selon un protocole de test prédéfini.

13. Procédé selon la revendication 12, dans lequel le courant désiré excède une limite de surintensité et le signal de sortie est un signal de détection de surintensité indiquant qu'un courant excessif circule dans le premier (12) de la première paire de dispositifs de commutation.

14. Procédé selon la revendication 12, dans lequel le signal de sortie est la tension aux bornes du premier (12) de la première paire de dispositifs de commutation.
